# EUROPEAN PATENT APPLICATION

(11) **EP 1 868 033 A2**
(43) Date of publication of application: **19.12.2007**
(21) Application number: 07011553.0
(22) Date of filing: 13.06.2007
(51) Int. Cl.: G03F 1/00, B29D 7/01, C08J 5/18

(54) **Pellicle**

(30) Priority: 14.06.2006 JP 2006164175
(71) Applicant: Shin-Etsu Chemical Co., Ltd., Tokyo (JP)
(72) Inventor: Hamada, Yuichi, c/o SHIN-ETSU CHEMICAL CO., LTD., Annaka-shi, Gunma (JP)
(74) Representative: Hoffmann, Klaus

(57) **Abstract**

A pellicle is provided that includes an aluminum alloy pellicle frame (3) having a polymer coating on the surface and a pellicle film (1) stretched over the peflicle frame. There is also provided a process for producing the pellicle in which the polymer coating is an electrodeposition-coated film, the process including a step of roughening the surface of the aluminum alloy pellicle frame by sandblasting, a step of etching the surface of the pellicle frame with an alkali solution, a step of electrodeposition coating the pellicle frame, and a step of stretching the pellicle film over the pellicle frame.

## Description

The present invention relates to a pellicle for lithography that is used as a debris shield for a lithography mask when producing a liquid crystal display panel or a semiconductor device such as an LSI or a ULSI.

In the production of a semiconductor such as an LSI or a ULSI or the production of a liquid crystal display panel, patterning is formed by irradiating a semiconductor wafer or a liquid crystal master plate with light; if debris is attached to an exposure master plate (lithography mask) used here, since the debris absorbs the light or bends the light, there are the problems that the replicated pattern is deformed, the edge becomes rough, or the background is stained black, thus impairing the dimensions, quality, appearance, etc.

Because of this, these operations are normally carried out in a clean room, but even within a clean room it is difficult to always keep the exposure master plate clean, and a method is therefore employed in which a pellicle that allows exposure light to easily pass through is adhered to the surface of the exposure master plate to act as a debris shield. In this case, the debris does not become attached directly to the surface of the exposure master plate but becomes attached to the pellicle film, and by focusing on a pattern of the exposure master plate when carrying out lithography the debris on the pellicle film does not become involved in the replication.

The pellicle has a basic constitution in which a transparent pellicle film made of nitrocellulose, cellulose acetate, a fluorine-based polymer, etc., which allows exposure light to easily pass through, is adhered to an upper part of a pellicle frame (frame) made of a black-anodized JIS A7075, A6061, A5052, etc. aluminum alloy, stainless steel, polyethylene, etc. by coating the upper part with a good solvent for the pellicle film and air-drying (ref. JP-A-58-219023 (JP-A denotes a Japanese unexamined patent application publication.)) or by means of an adhesive such as an acrylic resin, an epoxy resin, or a fluorine resin (ref. US Pat. No. 4861402 and JP-B-63-27707 (JP-B denotes a Japanese examined patent application publication.)) and, furthermore, since an exposure master plate is mounted on a lower part of the pellicle frame, the lower part is formed from a pressure-sensitive adhesion layer made of a polybutene resin, a polyvinyl acetate resin, an acrylic resin, a silicon resin, etc. and a reticle pressure-sensitive adhesive protecting liner for the purpose of protecting the pressure-sensitive adhesion layer.

The pellicle is installed so as to surround a pattern region formed on the surface of a mask substrate. Since the pellicle is provided in order to prevent debris from becoming attached to the mask substrate, this pattern region and a pellicle outer part are isolated so that dust from the pellicle outer part does not become attached to the pattern face.

In recent years, the LSI design rule has shrunk to sub-quarter micron, and accompanying this the wavelength of an exposure light source is being shortened, that is, instead of g rays (436 nm) and i rays (365 nm) from the hitherto predominant mercury lamp, a KeF excimer laser (248 nm), an ArF excimer laser (193 nm), an F₂ laser (157 nm), etc. are being used. When the wavelength of exposure light becomes shorter, the energy of the exposure light naturally becomes high. When high energy light is used, compared with light with a conventional wavelength, the possibility that gaseous material present in the exposure atmosphere will react so as to form a reaction product on the mask substrate becomes extremely high. Countermeasures have been taken, such as minimizing gaseous material within a clean room, carrying out rigorous washing of a reticle, removing gas-generating substances from materials forming a pellicle, etc. In particular, since the pellicle is used by affixing it directly to a mask substrate, there is a desire to decrease the amount of gas generated from the materials forming the pellicle, that is, a reticle adhesive, a film adhesive, an inner wall coating agent, etc., which are formed from organic materials, and improvements have been made. However, cloudy foreign matter, called haze, formed on the mask substrate cannot completely be prevented from occurring even by washing the reticle or reducing the amount of gas generated from the materials forming the pellicle, and this causes a decrease in the yield in semiconductor production.

It is an object of the present invention to provide a pellicle for which the formation of haze due to ammonium sulfate, etc. is suppressed by reducing the amount of water-soluble ion and reducing the amount of outgassing.

As a result of an intensive investigation by the present inventors in order to solve such problems, it has been found that an acid such as sulfuric acid, nitric acid, or an organic acid is taken into an anodized coating on the surface of an aluminum alloy used as a pellicle frame, this acid desorbs from the anodized coating on the frame surface under an exposure environment and builds up in a closed space between the pellicle and a mask, and when this acid is irradiated with short-wavelength UV rays during exposure, for example, a sulfate compound such as ammonium sulfate might be generated.

The present inventors have further found that forming a polymer coating on the surface of an aluminum alloy frame is effective; furthermore, it is preferable to employ electrodeposition coating for forming the polymer coating, and it is more preferable to employ anionic electrodeposition coating using a thermosetting resin. In accordance with these means, a pellicle that reduces the release of an acid such as sulfuric acid, nitric acid, or an organic acid contained in a conventional anodized coating can be prepared, and a pellicle having a low incidence of haze even under an exposure environment of short UV rays has thus been accomplished.

That is, the above-mentioned object of the present invention has been attained by means 1) below, which is described together with preferred embodiments 2) to 10).
1) A pellicle comprising an aluminum alloy pellicle frame having a polymer coating on the surface and a pellicle film stretched over the pellicle frame,
2) the pellicle according to 1), wherein the polymer coating is an electrodeposition-coated film,
3) the pellicle according to 1) or 2), wherein the polymer coating is an anionic electrodeposition-coated film of a thermosetting resin,
4) the pellicle according to any one of 1) to 3), wherein the polymer coating is a matte black electrodeposition-coated film and has an emissivity of 0.80 to 0.99,
5) the pellicle according to any one of 1) to 4), wherein the amount of sulfate ion leaching from the pellicle frame when immersed in pure water at 25°C for 168 hours is no greater than 1.0 ppm per pellicle frame weight,
6) the pellicle according to any one of 1) to 5), wherein the amount of organic acid ion leaching from the pellicle frame when immersed in pure water at 25°C for 168 hours is no greater than 1.0 ppm per pellicle frame weight,
7) the pellicle according to any one of 1) to 6), wherein the amount of nitrate ion leaching from the pellicle frame when immersed in pure water at 25°C for 168 hours is no greater than 0.5 ppm per pellicle frame weight,
8) the pellicle according to any one of 1) to 7), wherein the amount of organic outgas generated from the pellicle frame when heated at 130°C for 10 minutes is no greater than 10.0 ppm per pellicle frame weight,
9) the pellicle according to any one of 1) to 8), wherein the polymer coating has a thickness of 3 to 30 µm, and
10) the pellicle according to any one of 1) to 9), wherein the aluminum alloy is a JIS A7075 material, a JIS A6061 material, or a JIS A5052 material.

Providing a polymer coating on a pellicle frame made of an aluminum alloy enables a pellicle having a reduced content of sulfate ion, nitrate ion, organic acid, etc. to be provided. This has the effect of making it possible to cope with lithography employing a shorter wavelength by suppressing the occurrence of haze by reducing the content of sulfate ion, nitrate ion, organic acid, etc. contained in an anodized coating, which is a problem of the conventionally used pellicle frame with an anodized aluminum alloy surface, and by suppressing the amount of gas containing the acids that is generated from the pellicle frame.

The merit over cationic electrodeposition coating using a thermosetting resin is that the amount of gas generated from the frame surface during electrodeposition coating is smaller for the anionic type, and it is therefore possible to decrease the frequency of pin holes, etc. occurring on the surface.

It is also easy to remove attached foreign particles from the pellicle of the present invention.

### Brief description of drawing

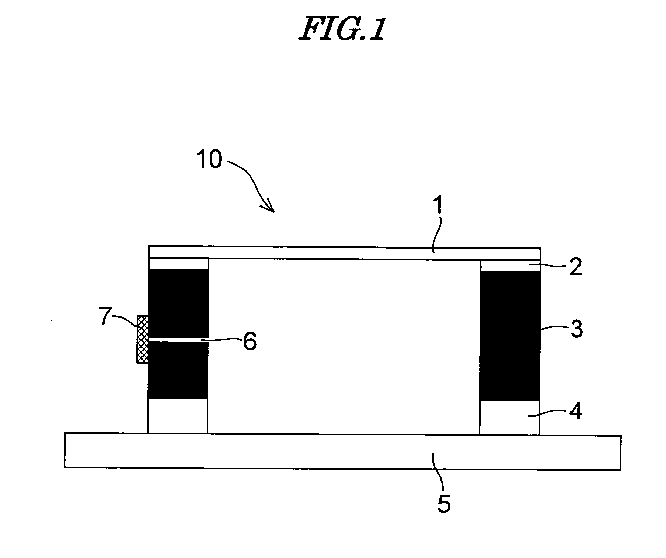

Fig. 1 shows a diagram for explaining a constitutional example of a pellicle.

The pellicle of the present invention comprises an aluminum alloy pellicle frame having a polymer coating provided on the surface, and a pellicle film stretched over the pellicle frame.

A pellicle equipped with a pellicle frame formed by providing an anodized coating on the surface of an aluminum alloy has been used conventionally. With regard to this pellicle frame, an acid such as sulfuric acid, an organic acid (oxalic acid, acetic acid, etc.), or nitric acid, or a salt thereof that has been incorporated into the anodized coating during formation of the coating, dyeing, sealing, or surface etching, etc. desorbs from the interior of the frame during irradiation with UV light (i rays or g rays, KrF laser, ArF laser, F₂ laser, etc.) in a lithographic step, exposure, or photomask storage, is generated as a gaseous material in a closed space formed between the pellicle and the photomask, and undergoes a photochemical reaction with ammonia, a cyan compound, or another hydrocarbon compound, etc. present in the environment under UV light during exposure or separately generated and supplied from the pellicle member, etc., thereby generating the cloudiness called haze, represented by ammonium sulfate, etc., or generating microparticles.

In the present invention, by coating the surface of a pellicle frame with a polymer so as to provide a polymer coating, it is possible to obtain a pellicle frame that reduces the generation of the acids released from the pellicle frame when it is used.

The present invention is explained below in further detail.

As shown in FIG. 1, a pellicle 10 of the present invention is formed by stretching a pellicle film 1 over an upper end face of a pellicle frame 3 via an adhesive 2 for affixing the pellicle film. In this case, a pressure-sensitive adhesion layer 4 for adhering the pellicle 10 to a exposure master plate (reticle) 5 is usually formed on a lower end face of the pellicle frame 3, and a liner (not illustrated) is detachably adhered to a lower end face of the pressure-sensitive adhesion layer 4 for adhering the reticle. The pellicle frame 3 is provided with an atmospheric pressure adjustment hole (vent) 6, and further with a dust filter 7 for the purpose of removing particles.

In this case, the dimensions of these pellicle components are similar to those of a normal pellicle, for example, a semiconductor pellicle for lithography, a pellicle for a lithographic step of large liquid crystal display panel production, etc., and the materials of the components may be known materials, as described above.

The type of pellicle film is not particularly limited and, for example, an amorphous fluorine polymer, etc. that has conventionally been used for an excimer laser is used. Examples of the amorphous fluorine polymer include Cytop (product name, manufactured by Asahi Glass Co. Ltd.) and Teflon (Registered Trademark) AF (product name, manufactured by DuPont). These polymers may be used by dissolving them in a solvent as necessary when preparing the pellicle film, and may be dissolved as appropriate in, for example, a fluorine-based solvent.

With regard to the base material of the pellicle frame used in the present invention, a conventionally used aluminum alloy material, and preferably a JIS A7075, JIS A6061, or JIS A5052 material, is used, but it is not particularly limited as long as it is an aluminum alloy and the strength as a pellicle frame is guaranteed. The surface of the pellicle frame is preferably roughened by sandblasting or chemical abrasion prior to providing a polymer coating. In the present invention, a method for roughening the surface of the frame may employ a conventionally known method. It is preferable to employ a method for roughening the surface involving blasting the aluminum alloy material surface with stainless steel, carborundum, glass beads, etc., and further by chemically abrading with NaOH, etc.

The polymer coating on the surface of the pellicle frame may be provided by various methods, and in general spray coating, electrostatic coating, electrodeposition coating, etc. can be cited as examples. In the present invention, it is preferable to provide a polymer coating by electrodeposition coating.

With regard to the electrodeposition coating, either a thermosetting resin or a UV curing resin may be used. It is also possible to employ either anionic electrodeposition coating or cationic electrodeposition coating for the resins. In the present invention, since UV resistance is required, it is preferable to employ anionic electrodeposition coating of a thermosetting resin in terms of coating stability, appearance, and strength.

The surface of the polymer coating is preferably matte-finished for the purpose of suppressing reflection. Furthermore, in order to suppress the generation of organic outgas from the polymer coating, the thickness of the electrodeposition-coated polymer coating is optimized and, moreover, conditions for baking after the electrodeposition coating are set so that, compared with conventional conditions, the temperature is higher and the time is longer for completion.

In accordance with a polymer coating being provided, unlike an anodized coating obtained by a conventional anodization method, it becomes possible to eliminate the inclusion and release of sulfate ion, nitrate ion, and organic acid. Since the polymer coating may be provided by coating without using sulfuric acid, nitric acid, an organic acid, etc. at all, either as a starting material or in the process, it is possible to simplify a washing step, etc., which has been necessary in order to decrease the conventional problems of sulfate ion, nitrate ion, and organic acid.

Techniques for electrodeposition coating (electrodeposition) are known to a person skilled in the art. For example, reference may be made to 1) S. Tamehiro, 'Denchakutoso (Electrodeposition Coating)' (The Nikkan Kogyo Shimbun Ltd., 1969), and 2) 'Kobunshi Daijiten' (Polymer Dictionary) (Maruzen, 1994) 'Toso/Denchaku' section (Coating/Electrodeposition) and references therein. In electrodeposition coating, resin particle ions dispersed in water are attracted by the surface of an electrode material having the opposite sign and are deposited, thus forming a polymer coating.

In the present invention, for the electrodeposition coating, a method involving anionic electrodeposition coating, in which the material to be coated is the anode, is preferred to a method involving cationic electrodeposition coating, in which the material to be coated is the cathode, since the amount of gas generated is smaller and there is less possibility of defects such as pinholes occurring in the coated film.

In the pellicle of the present invention, the polymer coating provided on the pellicle frame covers various types, such as an epoxy resin, an acrylic resin, an aminoacrylic resin, or a polyester resin, but it is preferable to form the polymer coating from a thermosetting resin rather than a thermoplastic resin. Examples of the thermosetting resin are primarily acrylic resins. After a thermosetting coating is electrodeposition coated, the coating may be thermally cured.

Furthermore, the polymer coating is preferably a matte black electrodeposition-coated film, using a matte paint colored with a black pigment.

Prior to electrodeposition coating, it is preferable to subject the aluminum alloy frame to surface roughening by sandblasting or surface etching by means of an alkali solution.

The thickness of the electrodeposition-coated polymer coating is preferably 3 to 30 µm, more preferably 5 to 30 µm, and particularly preferably 5 to 20 µm.

Coating equipment and a paint solution for electrodeposition coating used for these purposes may be purchased as commercial products from several Japanese companies and used. For example, an electrodeposition paint commercially available as Elecoat from Shimizu Co., Ltd. may be used. 'Elecoat Frosty W-2' and 'Elecoat Frosty ST Satiner' are matte type thermosetting anionic electrodeposition paints, and may preferably be used in the present invention.

When the polymer coating is a matte black electrodeposition-coated film, the emissivity is preferably 0.80 to 0.99. The 'emissivity' referred to here means a value obtained from P1/P, which is the ratio of the energy P1 radiated from a body to the total radiated energy P with a black body (an ideal body that absorbs all wavelengths incident on the surface and neither reflects nor transmits) as a reference, and is a value measured using a TSS-5X radiometer manufactured by Japan Sensor Corporation.

With regard to the pellicle of the present invention, the amounts of various types of anions leaching from the pellicle frame provided with the polymer coating by the polymer coating method are small.

Specifically, when immersed in pure water at 25°C for 168 hours, it is preferable for the amount of sulfate ion leaching per pellicle frame weight to be 1.0 ppm or less, for nitrate ion to be 0.5 ppm or less, and for the total of organic acid ions such as oxalic acid and formic acid to be 1.0 ppm or less. These anions are quantitatively analyzed by an ion chromatograph. Detailed measurement conditions are as described in Examples.

With regard to the pellicle of the present invention, it is preferable for the amount of organic outgas generated from the pellicle frame when stored at 130°C for 10 minutes to be 10.0 ppm or less per pellicle frame weight. Quantitative measurement is carried out by a GC-MS system. Detailed conditions for analysis are as described in Examples.

The anodized coating obtained by anodization, which has conventionally been applied to a pellicle frame, has marked surface irregularities due to its structure, is susceptible to cracking, etc., and easily allows foreign particles, etc. to become attached thereto, which are relatively difficult to remove by washing. The arrangement of the present invention, in which a polymer coating is provided, has the advantage that since the surface is smooth with few irregularities and is free from cracking, etc., attached particles can easily be removed.

The dust filter used in the present invention may be used in order to prevent particles from entering a space protected by affixing the pellicle, and this dust filter is not particularly limited in terms of shape, number, or location as long as it can be provided in the above-mentioned vent section. Examples of filter materials include resins (PTFE, nylon 66, etc.), metals (316L stainless steel, etc.), and ceramics (alumina, aluminum nitride, etc.). It is also preferable for the dust filter to be equipped on its exterior with a chemical filter for adsorbing or decomposing environmental chemical materials.

The adhesive for adhering the pellicle film may employ a conventionally used adhesive; examples thereof include an acrylic resin adhesive, an epoxy resin adhesive, a silicon resin adhesive, and a fluorine-based polymer such as a fluorine-containing silicon adhesive, and among them a fluorine-based polymer is suitable. Specific examples of the fluorine-based polymer include the fluorine-based polymer CT69 (product name, manufactured by Asahi Glass Co. Ltd.).

As adhesives for affixing the reticle, double-sided pressure-sensitive tape, a silicon resin pressure-sensitive adhesive, an acrylic pressure-sensitive adhesive, etc. can be cited.

The pellicle of the present invention may be produced by a normal method in which a pellicle film is stretched over an upper end face of a pellicle frame via an adhesive layer for adhering the pellicle film; an adhesive layer for affixing a reticle is normally formed on a lower end face of the pellicle frame, and a release layer is detachably affixed to a lower end face of the adhesive layer for affixing the reticle. Here, the adhesive layer for affixing the pellicle film formed on the upper end face of the pellicle frame may be formed by applying it to the upper end face of the pellicle frame after diluting it with a solvent as necessary, followed by heat drying and curing. In this case, as a method for applying the adhesive, a method involving brushing, spraying, an auto dispenser, etc. is employed.

The release layer for protecting the reticle adhesive that can be used in the present invention is not particularly limited in terms of material. Examples thereof include PET, PTFE, PFA, PE, PC, vinyl chloride, and PP.

### EXAMPLES

Examples are described below.

### Example 1

First, as a pellicle frame, a frame was prepared using an A7075-T651 aluminum alloy so that the frame outer dimensions were 149 mm x 122 mm x 5.8 mm and the frame thickness was 2 mm. A vent having a diameter of 0.5 mm was provided in the middle on one side face of the frame.

After the surface of the frame was washed, the surface was roughened by subjecting it to a surface treatment for 1 minute employing a sandblasting machine using glass beads with a discharge pressure of 1.5 kg/cm². Subsequently, the surface was etched by immersing it in an alkaline solution and then washed with water. After rinsing with pure water, it was subjected to electrodeposition coating with an Elecoat Frosty W-2 solution adjusted to 25°C (Shimizu Co., Ltd; thermosetting anionic type, matte type; black paint) so that the coating thickness would be 5 µm (since the coating thickness depended on the condition of the solution, a dummy frame was fed in advance, and the voltage and time for the electrodeposition step were determined each time based on actual measurement. This applies below.) After shower-rinsing with pure water, a heat treatment was carried out in an oven at 200°C for 30 minutes. The emissivity was 0.93.

One of the finished pellicle frames was cut into several pieces. They were placed in a polyethylene container, 100 mL of pure water was added thereto, the container was sealed, and immersion was carried out for 168 hours. Subsequently, the extracting water into which components had leached from the frame was analyzed using an ion chromatograph (Model 2050i, Dionex Corporation) and a Dionex IonPac ASA4A-SC column. The impurities detected in this extracting water were: sulfate ion not detected, nitrate ion not detected, chlorine ion 0.1 ppm, and organic acid (total amount of oxalic acid, formic acid, and acetic acid) 0.1 ppm.

Several frame pieces similarly cut were placed in a glass bottle, sampled using a head space sampler (Turbo Matrix HS, Perkin Elmer Japan Co., Ltd.) under conditions of 180°C for 30 minutes, and subjected to a GC-MS analysis using a GC-MS system (QP-5050A, Shimadzu Corporation) and an HP-5 column (film thickness 0.25 µm, inner diameter 0.25 mm, length 30 m). From the results, the total amount of organic outgas was 3.5 ppm relative to the weight of the frame.

Subsequently, an inner face of this frame was coated with a 3 µm thick silicon-based pressure-sensitive adhesive by means of a spray coater.

Furthermore, the above-mentioned vent was equipped with a filter made from a PTFE material and having 99.9999% dust filtration for a size of 0.1 µm to 3.0 µm, a width of 9.5 mm, a height of 2.5 mm, and a thickness of 300 µm. The filter had a structure in which there was a chemical filter outside the dust filter.

A solution having a concentration of 8% was prepared by dissolving Teflon (registered trademark) AF1600 (product name, DuPont, USA) in the fluorine-based solvent Fluorinert FC-75 (product name, 3M, USA). A mirror-polished silicon substrate face having a diameter of 300 mm and a thickness of 600 µm was coated with this solution using a spin coater, thus forming a 0.8 µm thick transparent film. A frame having outer dimensions of 200 mm x 200 mm x 5 mm wide and a thickness of 5 mm was adhered to the film using the epoxy-based adhesive Araldite Rapid (product name, Showa Highpolymer Co., Ltd.) and it was peeled off.

One end face of the aluminum alloy frame prepared above was coated with a silicon-based pressure-sensitive adhesive, heated at 150°C for 10 minutes, dried, and cured. The other end face of this aluminum alloy frame was coated with the fluorine-based polymer Polymer CTX (product name, Asahi Glass Co. Ltd.) diluted with the fluorine-based solvent CT-Solve 180 (product name, Asahi Glass Co. Ltd.), heated at 100°C for 10 minutes, dried, and cured. A liner made of PET was prepared, and bonded to a reticle adhesive by means of a liner-affixing system having an image processing positioning mechanism equipped with a CCD camera. Subsequently, it was brought into intimate contact with the surface of the prepared Teflon (registered trademark) AF1600 film, and the frame and the film were then fusion bonded by heating the frame by means of an IR lamp. The two frames were mounted on a fixing jig with the adhesion face of the pellicle frame upward, and fixed so that their relative positions were not displaced. Subsequently, the frame outside the pellicle frame was pulled up and fixed, and a tension of 0.5 g/cm was applied to a film portion outside the pellicle frame.

Subsequently, unwanted film sections outside the pellicle frame were cut and removed using a tube-type dispenser on a cutter mounted on a SCARA robot while moving the cutter along the periphery of the adhesive section of the pellicle frame and dropping Fluorinert FC-75 (product name, DuPont) at 10 µL per minute.

The completed pellicle was affixed to a 6 inch photomask substrate made of quartz glass with a Cr test pattern formed thereon, which had been washed so that the concentration of residual surface acid components was 1 ppb or less. Subsequently, this was mounted on an NSR S306C ArF excimer laser scanner (product name, Nikon Corporation), and irradiated at a reticle face exposure strength of 0.02 mJ/cm²/pulse and a repetition frequency of 4000 Hz up to an exposure of 500 J/cm².

When the irradiated 6 inch photomask was examined by means of a laser foreign matter detector, there was no haze and no foreign matter in either the test pattern section or the glass section.

### Example 2

In the same manner as in Example 1, as a pellicle frame, a frame was prepared using an A7075-T651 aluminum alloy so that the frame outer dimensions were 149 mm x 122 mm x 5.8 mm and the frame thickness was 2 mm. A vent having a diameter of 0.5 mm was provided in the middle on one side face of the frame.

After the surface of the pellicle frame was washed, the surface was roughened by subjecting it to a surface treatment for 1 minute employing a sandblasting machine using glass beads with a discharge pressure of 1.5 kg/cm². Subsequently, the surface was etched by immersing it in an alkaline solution and then washed with water. After rinsing with pure water, it was subjected to electrodeposition coating with an Elecoat Frosty W-2 solution adjusted to 25°C (Shimizu Co., Ltd) so that the coating thickness would be 18 µm (since the coating depended on the condition of the solution, a dummy frame was fed in advance, and the voltage and time for the electrodeposition step were determined each time based on actual measurement.) After shower-rinsing with pure water, a heat treatment was carried out in an oven at 200°C for 30 minutes.

When analysis was carried out in the same manner as in Example 1, the impurities detected were: sulfate ion not detected, nitrate ion not detected, chlorine ion 0.1 ppm, and organic acid (total amount of oxalic acid, formic acid, and acetic acid) 0.1 ppm.

Several frame pieces similarly cut were placed in a glass bottle, sampled using a head space sampler (Turbo Matrix HS, Perkin Elmer Japan Co., Ltd.) under conditions of 180°C for 30 minutes, and subjected to a GC-MS analysis using a GC-MS system (QP-5050A, Shimadzu Corporation) and an HP-5 column (film thickness 0.25 µm, inner diameter 0.25 mm, length 30 m). From the results, the total amount of organic outgas was 9.3 ppm relative to the weight of the frame.

Furthermore, an inner face of this frame was coated with a 3 µm thick silicon-based pressure-sensitive adhesive by means of a spray coater. Subsequently, the above-mentioned vent was equipped with a filter made from a PTFE material and having 99.9999% dust filtration for a size of 0.1 µm to 3.0 µm, a width of 9.5 mm, a height of 2.5 mm, and a thickness of 300 µm. The filter had a structure in which there was a chemical filter outside the dust filter. A solution having a concentration of 8% was prepared by dissolving Teflon (registered trademark) AF1600 (product name, DuPont, USA) in the fluorine-based solvent Fluorinert FC-75 (product name, 3M, USA). A mirror-polished silicon substrate face having a diameter of 300 mm and a thickness of 600 µm was coated with this solution using a spin coater, thus forming a 0.8 µm thick transparent film.

Subsequently, a frame having outer dimensions of 200 mm x 200 mm x 5 mm wide and a thickness of 5 mm was adhered to the film using the epoxy-based adhesive Araldite Rapid (product name, Showa Highpolymer Co., Ltd.) and it was peeled off.

One end face of the aluminum alloy frame prepared above was coated with a silicon-based pressure-sensitive adhesive, heated at 150°C for 10 minutes, dried, and cured. The other end face of this aluminum alloy frame was coated with the fluorine-based polymer Polymer CTX (product name, Asahi Glass Co. Ltd.) diluted with the fluorine-based solvent CT-Solve 180 (product name, Asahi Glass Co. Ltd.), heated at 100°C for 10 minutes, dried, and cured. A liner made of PET was prepared, and bonded to a reticle adhesive by means of a liner-affixing system having an image processing positioning mechanism equipped with a CCD camera. Subsequently, it was brought into intimate contact with the surface of the prepared Teflon (registered trademark) AF1600 film, and the frame and the film were then fusion bonded by heating the frame by means of an IR lamp. The two frames were mounted on a fixing jig with the adhesion face of the pellicle frame upward, and fixed so that their relative positions were not displaced. Subsequently, the frame outside the pellicle frame was pulled up and fixed, and a tension of 0.5 g/cm was applied to a film portion outside the pellicle frame.

Subsequently, unwanted film sections outside the pellicle frame were cut and removed using a tube-type dispenser on a cutter mounted on a SCARA robot while moving the cutter along the periphery of the adhesive section of the pellicle frame and dropping Fluorinert FC-75 (product name, DuPont) at 10 µL per minute.

The completed pellicle was affixed to a 6 inch photomask substrate made of quartz glass with a Cr test pattern formed thereon, which had been washed so that the concentration of residual surface acid components was 1 ppb or less. Subsequently, this was mounted on an NSR S306C ArF excimer laser scanner (product name, Nikon Corporation), and irradiated at a reticle face exposure strength of 0.02 mJ/cm²/pulse and a repetition frequency of 4000 Hz up to an exposure of 500 J/cm².

When the irradiated 6 inch photomask was examined by means of a laser foreign matter detector, there was no haze and no foreign matter in either the test pattern section or the glass section.

### Example 3

In the same manner as in Example 1, as a pellicle frame, a frame was prepared using an A7075-T651 aluminum alloy so that the frame outer dimensions were 149 mm x 122 mm x 5.8 mm and the frame thickness was 2 mm. A vent having a diameter of 0.5 mm was provided in the middle on one side face of the frame.

After the surface of the frame was washed, the surface was roughened by subjecting it to a surface treatment for 1 minute employing a sandblasting machine using glass beads with a discharge pressure of 1.5 kg/cm². Subsequently, the surface was etched by immersing it in an alkaline solution and then washed with water. After rinsing with pure water, it was subjected to electrodeposition coating with an Elecoat Frosty W-2 solution adjusted to 25°C (Shimizu Co., Ltd) so that the coating thickness would be 3 µm. After shower-rinsing with pure water, a heat treatment was carried out in an oven at 200°C for 30 minutes.

When analysis was carried out in the same manner as in Example 1, the impurities detected were: sulfate ion not detected, nitrate ion not detected, chlorine ion 0.1 ppm, and organic acid (total amount of oxalic acid, formic acid, and acetic acid) 0.1 ppm.

Several frame pieces similarly cut were placed in a glass bottle, sampled using a head space sampler (Turbo Matrix HS, Perkin Elmer Japan Co., Ltd.) under conditions of 180°C for 30 minutes, and subjected to a GC-MS analysis using a GC-MS system (QP-5050A, Shimadzu Corporation) and an HP-5 column (film thickness 0.25 µm, inner diameter 0.25 mm, length 30 m). From the results, the total amount of organic outgas was 1.8 ppm relative to the weight of the frame.

Subsequently, an inner face of this frame was coated with a 3 µm thick silicon-based pressure-sensitive adhesive by means of a spray coater.

Furthermore, the above-mentioned vent was equipped with a filter made from a PTFE material and having 99.9999% dust filtration for a size of 0.1 µm to 3.0 µm, a width of 9.5 mm, a height of 2.5 mm, and a thickness of 300 µm. The filter had a structure in which there was a chemical filter outside the dust filter.

A solution having a concentration of 8% was prepared by dissolving Teflon (registered trademark) AF1600 (product name, DuPont, USA) in the fluorine-based solvent Fluorinert FC-75 (product name, 3M, USA).

A mirror-polished silicon substrate face having a diameter of 300 mm and a thickness of 600 µm was coated with this solution using a spin coater, thus forming a 0.8 µm thick transparent film.

Subsequently, a frame having outer dimensions of 200 mm x 200 mm x 5 mm wide and a thickness of 5 mm was adhered to the film using the epoxy-based adhesive Araldite Rapid (product name, Showa Highpolymer Co., Ltd.) and it was peeled off.

One end face of the aluminum alloy frame prepared above was coated with a silicon-based pressure-sensitive adhesive, heated at 150°C for 10 minutes, dried, and cured. The other end face of this aluminum alloy frame was coated with the fluorine-based polymer Polymer CTX (product name, Asahi Glass Co. Ltd.) diluted with the fluorine-based solvent CT-Solve 180 (product name, Asahi Glass Co. Ltd.), heated at 100°C for 10 minutes, dried, and cured. A liner made of PET was prepared, and bonded to a reticle adhesive by means of a liner-affixing system having an image processing positioning mechanism equipped with a CCD camera. Subsequently, it was brought into intimate contact with the surface of the prepared Teflon (registered trademark) AF1600 film, and the frame and the film were then fusion bonded by heating the frame by means of an IR lamp. The two frames were mounted on a fixing jig with the adhesion face of the pellicle frame upward, and fixed so that their relative positions were not displaced. Subsequently, the frame outside the pellicle frame was pulled up and fixed, and a tension of 0.5 g/cm was applied to a film portion outside the pellicle frame.

Subsequently, unwanted film sections outside the pellicle frame were cut and removed using a tube-type dispenser on a cutter mounted on a SCARA robot while moving the cutter along the periphery of the adhesive section of the pellicle frame and dropping Fluorinert FC-75 (product name, DuPont) at 10 µL per minute.

The completed pellicle was affixed to a 6 inch photomask substrate made of quartz glass with a Cr test pattern formed thereon, which had been washed so that the concentration of residual surface acid components was 1 ppb or less. Subsequently, this was mounted on an NSR S306C ArF excimer laser scanner (product name, Nikon Corporation), and irradiated at a reticle face exposure strength of 0.02 mJ/cm²/pulse and a repetition frequency of 4000 Hz up to an exposure of 500 J/cm².

When the irradiated 6 inch photomask was examined by means of a laser foreign matter detector, there was no haze and no foreign matter in either the test pattern section or the glass section.

However, since a frame inner wall of the completed pellicle had uneven color and noticeable bright points due to pin holes, which were hard to differentiate from foreign matter and contamination on the inner wall, it was necessary to improve the pellicle appearance.

### Example 4

In the same manner as in Example 1, as a pellicle frame, a frame was prepared using an A7075-T651 aluminum alloy so that the frame outer dimensions were 149 mm x 122 mm x 5.8 mm and the frame thickness was 2 mm. A vent having a diameter of 0.5 mm was provided in the middle on one side face of the frame.

After the surface of the frame was washed, the surface was roughened by subjecting it to a surface treatment for 1 minute employing a sandblasting machine using glass beads with a discharge pressure of 1.5 kg/cm². Subsequently, the surface was etched by immersing it in an alkaline solution and then washed with water. After rinsing with pure water, it was subjected to electrodeposition coating with an Elecoat Frosty W-2 solution adjusted to 25°C (Shimizu Co., Ltd.) so that the coating thickness would be 23 µm. After shower-rinsing with pure water, a heat treatment was carried out in an oven at 200°C for 30 minutes.

One of the finished pellicle frames was cut into several pieces. They were placed in a polyethylene container, 100 mL of pure water was added thereto, the container was sealed, and immersion was carried out for 168 hours. Subsequently, the extracting water into which components had leached from the frame was analyzed using an ion chromatograph (Model 2050i, Dionex Corporation) and a Dionex IonPac ASA4A-SC column. The impurities detected in this extracting water were: sulfate ion not detected, nitrate ion not detected, chlorine ion 0.1 ppm, and organic acid (total amount of oxalic acid, formic acid, and acetic acid) 0.1 ppm.

Several frame pieces similarly cut were placed in a glass bottle, sampled using a head space sampler (Turbo Matrix HS, Perkin Elmer Japan Co., Ltd.) under conditions of 180°C for 30 minutes, and subjected to a GC-MS analysis using a GC-MS system (QP-5050A, Shimadzu Corporation) and an HP-5 column (film thickness 0.25 µm, inner diameter 0.25 mm, length 30 m). From the results, the total amount of organic outgas was 18.0 ppm relative to the weight of the frame.

Subsequently, an inner face of this frame was coated with a 3 µm thick silicon-based pressure-sensitive adhesive by means of a spray coater.

Subsequently, the above-mentioned vent was equipped with a filter made from a PTFE material and having 99.9999% dust filtration for a size of 0.1 µm to 3.0 µm, a width of 9.5 mm, a height of 2.5 mm, and a thickness of 300 µm. The filter had a structure in which there was a chemical filter outside the dust filter.

Subsequently, a solution having a concentration of 8% was prepared by dissolving Teflon (registered trademark) AF1600 (product name, DuPont, USA) in the fluorine-based solvent Fluorinert FC-75 (product name, 3M, USA).

A mirror-polished silicon substrate face having a diameter of 300 mm and a thickness of 600 µm was then coated with this solution using a spin coater, thus forming a 0.8 µm thick transparent film.

A frame having outer dimensions of 200 mm x 200 mm x 5 mm wide and a thickness of 5 mm was then adhered to the film using the epoxy-based adhesive Araldite Rapid (product name, Showa Highpolymer Co., Ltd.) and it was peeled off.

Subsequently, one end face of the aluminum alloy frame prepared above was coated with a silicon-based pressure-sensitive adhesive, heated at 150°C for 10 minutes, dried, and cured. The other end face of this aluminum alloy frame was coated with the fluorine-based polymer Polymer CTX (product name, Asahi Glass Co. Ltd.) diluted with the fluorine-based solvent CT-Solve 180 (product name, Asahi Glass Co. Ltd.), heated at 100°C for 10 minutes, dried, and cured. A liner made of PET was prepared, and bonded to a reticle adhesive by means of a liner-affixing system having an image processing positioning mechanism equipped with a CCD camera. Subsequently, it was brought into intimate contact with the surface of the prepared Teflon (registered trademark) AF1600 film, and the frame and the film were then fusion bonded by heating the frame by means of an IR lamp. The two frames were mounted on a fixing jig with the adhesion face of the pellicle frame upward, and fixed so that their relative positions were not displaced. Subsequently, the frame outside the pellicle frame was pulled up and fixed, and a tension of 0.5 g/cm was applied to a film portion outside the pellicle frame.

Subsequently, unwanted film sections outside the pellicle frame were cut and removed using a tube-type dispenser on a cutter mounted on a SCARA robot while moving the cutter along the periphery of the adhesive section of the pellicle frame and dropping Fluorinert FC-75 (product name, DuPont) at 10 µL per minute.

The completed pellicle was affixed to a 6 inch photomask substrate made of quartz glass with a Cr test pattern formed thereon, which had been washed so that the concentration of residual surface acid components was 1 ppb or less. Subsequently, this was mounted on an NSR S306C ArF excimer laser scanner (product name, Nikon Corporation), and irradiated at a reticle face exposure strength of 0.02 mJ/cm²/pulse and a repetition frequency of 4000 Hz up to an exposure of 500 J/cm².

When the irradiated 6 inch photomask was examined by means of a laser foreign matter detector, there was no haze and no foreign matter in either the test pattern section or the glass section, but a white haze was observed on the inside of the film on the periphery of the pellicle frame. When the cloudy section was analyzed by means of a laser Raman spectroscope, it was found to be a hydrocarbon-based material.

### Comparative Example 1

First, as a pellicle frame, a frame was prepared using an A7075-T651 aluminum alloy so that the frame outer dimensions were 149 mm x 122 mm x 5.8 mm and the frame thickness was 2 mm. A vent having a diameter of 0.5 mm was provided in the middle on one side face of the frame.

After the surface thereof was washed, the surface was roughened by subjecting it to a surface treatment for 1 minute employing a sandblasting machine using glass beads with a discharge pressure of 1.5 kg/cm². Subsequently, this was washed in a NaOH treatment bath for 10 sec, and anodization was then carried out at a formation voltage of 10 V (1.3 A) in a 14% aqueous solution of sulfuric acid. Subsequently, a black oxide coating was formed on the surface by black staining and sealing treatments. When the average coating thickness was measured, it was found to be 12 µm. After this, it was washed for 5 minutes by the use of ultrapure water and an ultrasonic washing system in combination.

One of the finished pellicle frames was cut into several pieces. They were placed in a polyethylene container, 100 mL of pure water was added thereto, the container was sealed, and immersion was carried out for 168 hours. Subsequently, the extracting water into which components had leached from the frame was analyzed using an ion chromatograph (Model 2050i, Dionex Corporation) and a Dionex IonPac ASA4A-SC column. The impurities detected in this extracting water were: sulfate ion 4.1 ppm, nitrate ion 0.6 ppm, chlorine ion 1.0 ppm, and organic acid (total amount of oxalic acid, formic acid, and acetic acid) 1.1 ppm.

Several frame pieces similarly cut were placed in a glass bottle, sampled using a head space sampler (Turbo Matrix HS, Perkin Elmer Japan Co., Ltd.) under conditions of 180°C for 30 minutes, and subjected to a GC-MS analysis using a GC-MS system (QP-5050A, Shimadzu Corporation) and an HP-5 column (film thickness 0.25 µm, inner diameter 0.25 mm, length 30 m). From the results, the total amount of organic outgas was 0.4 ppm relative to the weight of the frame.

Subsequently, an inner face of this frame was coated with a 3 µm thick silicon-based pressure-sensitive adhesive by means of a spray coater.

Subsequently, the above-mentioned vent was equipped with a filter made from a PTFE material and having 99.9999% dust filtration for a size of 0.1 µm to 3.0 µm, a width of 9.5 mm, a height of 2.5 mm, and a thickness of 300 µm. The filter had a structure in which there was a chemical filter outside the dust filter.

Subsequently, a solution having a concentration of 8% was prepared by dissolving Teflon (registered trademark) AF1600 (product name, DuPont, USA) in the fluorine-based solvent Fluorinert FC-75 (product name, 3M, USA).

A mirror-polished silicon substrate face having a diameter of 300 mm and a thickness of 600 µm was then coated with this solution using a spin coater, thus forming a 0.8 µm thick transparent film.

A frame having outer dimensions of 200 mm x 200 mm × 5 mm wide and a thickness of 5 mm was then adhered to the film using the epoxy-based adhesive Araldite Rapid (product name, Showa Highpolymer Co., Ltd.) and it was peeled off.

Subsequently, one end face of the aluminum alloy frame prepared above was coated with a silicon-based pressure-sensitive adhesive, heated at 150°C for 10 minutes, dried, and cured. The other end face of this aluminum alloy frame was coated with the fluorine-based polymer Polymer CTX (product name, Asahi Glass Co. Ltd.) diluted with the fluorine-based solvent CT-Solve 180 (product name, Asahi Glass Co. Ltd.), heated at 100°C for 10 minutes, dried, and cured. A liner made of PET was prepared, and bonded to a reticle adhesive by means of a liner-affixing system having an image processing positioning mechanism equipped with a CCD camera. Subsequently, it was brought into intimate contact with the surface of the prepared Teflon (registered trademark) AF1600 film, and the frame and the film were then fusion bonded by heating the frame by means of an IR lamp. The two frames were mounted on a fixing jig with the adhesion face of the pellicle frame upward, and fixed so that their relative positions were not displaced. Subsequently, the frame outside the pellicle frame was pulled up and fixed, and a tension of 0.5 g/cm was applied to a film portion outside the pellicle frame.

Subsequently, unwanted film sections outside the pellicle frame were cut and removed using a tube-type dispenser on a cutter mounted on a SCARA robot while moving the cutter along the periphery of the adhesive section of the pellicle frame and dropping Fluorinert FC-75 (product name, DuPont) at 10 µL per minute.

The completed pellicle was affixed to a 6 inch photomask substrate made of quartz glass with a Cr test pattern formed thereon, which had been washed so that the concentration of residual surface acid components was 1 ppb or less. Subsequently, this was mounted on an NSR S306C ArF excimer laser scanner (product name, Nikon Corporation), and irradiated at a reticle face exposure strength of 0.02 mJ/cm²/pulse and a repetition frequency of 4000 Hz up to an exposure of 500 J/cm².

When the irradiated 6 inch photomask was examined by means of a laser foreign matter detector, there was no haze and no foreign matter in the test pattern section, but haze was observed in the glass section. When this was analyzed by means of a laser Raman spectroscope, it was found to be ammonium sulfate.

The above-mentioned Examples and Comparative Example are summarized in Table 1.

Detection limits for sulfate ion and nitrate ion were 0.1 ppm or less.

**(Table 1)**

| | Method for forming coating | Coating thickness (µm) | Leached ion (ppm) | | | | Outgas (ppm) | Occurrence of haze | Frame appearance |
|---|---|---|---|---|---|---|---|---|---|
| | | | Sulfate ion | Nitrate ion | Organic acid | Chloride ion | | | |
| Ex.1 | Anionic electrodeposition coating | 5 | N.D. | N.D. | 0.1 | 0.1 | 3.5 | N.D. | Good |
| Ex. 2 | Anionic electrodeposition coating | 18 | N.D. | N.D. | 0.1 | 0.1 | 9.3 | N.D. | Good |
| Ex.3 | Anionic electrodeposition coating | 3 | N.D. | N.D. | 0.1 | 0.1 | 1.8 | N.D. | Uneven color, pinholes |
| Ex. 4 | Anionic electrodeposition coating | 23 | N.D. | N.D. | 0.1 | 0.1 | 18.0 | Hydrocarbon | Good |
| Comp. Ex. 1 | Anodizing | 12 | 4.1 | 0.6 | 1.1 | 1 | 0.4 | Ammonium sulfate | Good |

| | | | | | | | | | |
|---|---|---|---|---|---|---|---|---|---|
| N.D. Not detected. Organic acid is the total amount of organic acids such as oxalic acid and formic acid. | | | | | | | | | |

## Claims

1. A pellicle comprising:
an aluminum alloy pellicle frame having a polymer coating on the surface; and
a pellicle film stretched over the pellicle frame.

2. The pellicle according to Claim 1, wherein the polymer coating is an electrodeposition-coated film.

3. The pellicle according to Claim 1 or 2, wherein the polymer coating is an anionic electrodeposition-coated film of a thermosetting resin.

4. The pellicle according to any one of Claims 1 to 3, wherein the polymer coating is a matte black electrodeposition-coated film and has an emissivity of 0.80 to 0.99.

5. The pellicle according to any one of Claims 1 to 4, wherein the amount of sulfate ion leaching from the pellicle frame when immersed in pure water at 25°C for 168 hours is no greater than 1.0 ppm per pellicle frame weight.

6. The pellicle according to any one of Claims 1 to 5, wherein the amount of organic acid ion leaching from the pellicle frame when immersed in pure water at 25°C for 168 hours is no greater than 1.0 ppm per pellicle frame weight.

7. The pellicle according to any one of Claims 1 to 6, wherein the amount of nitrate ion leaching from the pellicle frame when immersed in pure water at 25°C for 168 hours is no greater than 0.5 ppm per pellicle frame weight.

8. The pellicle according to any one of Claims 1 to 7, wherein the amount of organic outgas generated from the pellicle frame when heated at 130°C for 10 minutes is no greater than 10.0 ppm per pellicle frame weight.

9. The pellicle according to any one of Claims 1 to 8, wherein the polymer coating has a thickness of 3 to 30 µm.

10. The pellicle according to any one of Claims 1 to 9, wherein the aluminum alloy is a JIS A7075 material, a JIS A6061 material, or a JIS A5052 material.
